(19) Europäisches Patentamt
European Patent Office
Office européen des brevets

(11) **EP 2 984 684 B1**

(12) **EUROPEAN PATENT SPECIFICATION**

(45) Date of publication and mention
of the grant of the patent:
**02.06.2021 Bulletin 2021/22**

(51) Int Cl.:
*H01L 31/101* *(2006.01)*    *H01L 29/00* *(2006.01)*
*G01N 21/01* *(2006.01)*    *G02B 6/43* *(2006.01)*
*G02B 6/122* *(2006.01)*    *G02B 6/10* *(2006.01)*

(21) Application number: **14782288.6**

(22) Date of filing: **11.04.2014**

(86) International application number:
**PCT/US2014/033862**

(87) International publication number:
**WO 2014/169246 (16.10.2014 Gazette 2014/42)**

(54) **SPASER TO SPEED UP CMOS PROCESSORS**

SPASER ZUR BESCHLEUNIGUNG VON CMOS-PROZESSOREN

SPASER POUR ACCÉLÉRER DES PROCESSEURS CMOS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.04.2013 US 201361811399 P
26.04.2013 US 201361816387 P**

(43) Date of publication of application:
**17.02.2016 Bulletin 2016/07**

(73) Proprietor: **GEORGIA STATE UNIVERSITY
RESEARCH FOUNDATION
Atlanta, GA 30303-3085 (US)**

(72) Inventor: **STOCKMAN, Mark, I.
Atlanta, GA 30340 (US)**

(74) Representative: **Grünecker Patent- und
Rechtsanwälte
PartG mbB
Leopoldstraße 4
80802 München (DE)**

(56) References cited:
**EP-A1- 1 939 657    WO-A2-2012/015990
WO-A2-2012/015990    US-A1- 2003 179 974
US-A1- 2009 065 801    US-A1- 2009 065 801
US-A1- 2009 243 589    US-A1- 2010 129 085
US-A1- 2010 316 078    US-B2- 7 569 188**

**Description**

**TECHNICAL FIELD**

This disclosure relates generally to the field of semiconductor and plasmonic devices, and more particularly to surface plasmon amplification by stimulated emission of radiation for improving an operational speed and energy efficiency of a CMOS processor.

**BACKGROUND**

In conventional processors, while transistors (e.g., metal-oxide semiconductor field effect transistors (MOSFETs)) that form an integral part of a processor work at speeds up to the limit of their cutoff frequency ($f_{cutoff}$), the processors themselves work significantly slower (e.g., typically two orders of magnitude) than the transistors. For example, operational speed of transistors (MOSFET) in a processor is approximately 100-300 GHz, while the operational speed (clock rate) of the processor is about or below 3 GHz. Even though a new generation of transistors and processors are produced every two years (following, so far, Moore's law), the speed of the processors have continued to remain significantly slower than the operational speed of the underlying transistors that form the processors.

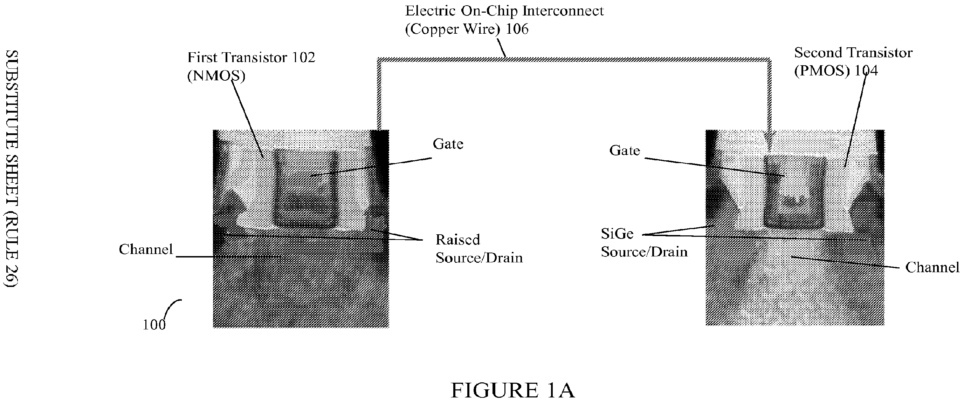

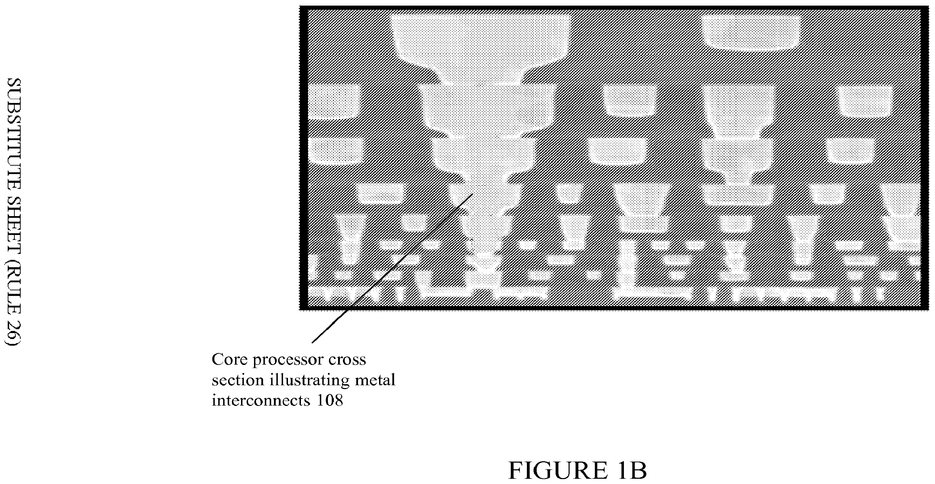

The slower operational speed of conventional processors 100 can be attributed to metal interconnect wires 108 that occupy most of the processor volume as illustrated in **Figure 1B.** Further, as illustrated in **Figure 1A,** conventional processors are built on CMOS technology where the drive (output) current of one transistor electrostatically charges an interconnect wire and the gate of the complementary transistor. In particular, **Figure 1A** illustrates configuration of an example transistor pair of a processor 100 comprising a first transistor 102 that electrostatically charges the interconnect copper wire 106 which in turn charges the gate of the second transistor 104. This electrostatic charging of an interconnect wire in a processor limits the processor speed at least due to an effect of the resistance (R) and capacitance (C) of the interconnect wire. In particular, the resistance and capacitance of the interconnect wire defines the maximum achievable processor speed as f = 1/RC. Accordingly, by using standard expressions for resistance and capacitance as shown in Equation 1, standard expression for maximum achievable processor speed as shown in Equation 2, and substituting realistic values for the parameters of the Equation 1 and Equation 2, it can be observed that the maximum achievable processor speed is much slower than the intrinsic transistor speed $f_{cutoff}$.

$$C = \frac{\varepsilon L}{2 ln \frac{L}{A}} \quad , \quad R = \frac{L}{\pi \sigma a^2} \qquad (1)$$

and

$$f_{RC} = \frac{1}{RC} \qquad (2)$$

For example, in the above-mentioned Equation 1, L which is the interconnect wire length can be realistically set as 1mm, 'a' which is its radius of the interconnect wire can be realistically set as 10 nm, $\varepsilon \sim 8$ is the permittivity of the surrounding material in the processors (average that of silicon (11.9) and silicon dioxide (3.9)), and $\sigma \sim 6 \times 10^7$ Mho/m is the conductivity of copper. On the basis of the values of each parameter provided above, the maximum achievable processor speed can be derived to be 2.4 GHz which is close to that of actual processors [Pasricha, S. & Dutt, N. *On-chip Communication Architectures: System on Chip Interconnect* (Morgan Kaufmann, 2008)] and two orders of magnitude smaller than the intrinsic transistor speed, which is approximately 100-300 GHz.

Further, currently, the speed of conventional processors are not defined by maximum transistor speed, i.e., the cutoff frequency $f_{cutoff}$ of the transistor because $f_{cutoff} \gg f_{RC}$, which makes the cutoff frequency irrelevant for defining the processor speed. Instead, the technical descriptions define the processor speed based on the output or drive current of the transistor, i.e., $I_d \sim 1\mu A$ per nm of the gate width of the transistor, which for typical 30 nm gate yields $I_d \sim 30 \mu A$ [Packan, P. et al. High performance 32 nm logic technology featuring 2nd generation high-k + metal gate transistors, in: 2009 IEEE International Electron Devices Meeting (IEDM) 1-4 (2009)]. The drive current may define the processor speed because it the drive current of the underlying transistor that charges of the interconnect wire to a potential difference $\Delta U \sim 0.25$ V, which is needed to control the complimentary transistor in the processor (e.g., in processors where transistors work in pairs). This limits the processor's maximum speed to [Krausz, F. & Stockman, M.I. Attosecond metrology: from electron capture to future signal processing. Nature Photonics doi: 10.1038/nphoton.2014.28 (2014)]:

$$f_{max} = I_d/(C \, \Delta U) \sim 3 \text{ GHz}, \qquad\qquad (3)$$

which is close to the maximum actual processor speed of contemporary processors [Pasricha, S. & Dutt, N. On-chip Communication Architectures: System on Chip Interconnect (Morgan Kaufmann, 2008)].

The significant slowing down of the processor speed, e.g., by two orders of magnitude with respect to the transistor speed, $f_{cutoff}$, results in a commensurate decrease of the energy efficiency of the processor by the same factor. Further, the decrease in the energy efficiency of the processor can also be attributed to the fact that the electrostatic energy stored in interconnect wires are wasted when the transistors switch because only energy which is stored in the orders of magnitude smaller (than that of the wires) gate capacitance of the transistor (e.g., MOSFET) is useful because it defines the drive current, and consequently, the transistor and processor functionalities. As a result, conventional processors have a high heat production per operation. Accordingly, there exists a need for technology that can overcome the above-mentioned shortcomings and improve an operational speed of the conventional processors.

US 2009/065801 A1 discloses a surface plasmon polaritron activated semiconductor device which uses a surface plasmon wire that functions as an optical waveguide for fast communication of a signal and functions as a energy translator using a wire tip for translating the optical signal passing through the waveguide into plasmon-polaritron energy at a connection of the semiconductor device, such as a transistor, to activate the transistor for improved speed of communications and switching for preferred use in digital systems.

US 2010/316078 A1 discloses a surface plasmon-generating apparatus which includes an active layer including an n-type region formed on one side and a p-type region formed on the other side, the n-type region and the p-type region being in contact with each other to form a pn junction therebetween; a first barrier layer in contact with a first surface of the active layer; a second barrier layer in contact with a second surface of the active layer, the second surface being opposite the first surface; and a metal body disposed above the pn junction of the active layer with the second barrier layer and an insulating layer therebetween.

EP 1 939 657 A discloses an interconnection network between a first semiconductor structure and a second semiconductor structure. The interconnection network comprises a transmitter for transmitting a signal originating from said first semiconductor structure, said transmitter being electrically connected to said first semiconductor structure and being adapted to convert said signal to a modulated plasmon wave, a waveguide extending from said first semiconductor structure to said second semiconductor structure and cooperating with said transmitter to receive said modulated plasmon wave, and a receiver cooperating with said waveguide to receive said modulated plasmon wave and being adapted to convert it to a modulated electric signal, said receiver being electrically connected to said second semiconductor structure.

It is the object of the present invention to enable an improved operation of a CMOS transistor pair.

The object of the invention is solved by the subject matter of the independent claims.

Preferred embodiments of the present invention are defined by the dependent claims.

## SUMMARY

The present disclosure can address the needs described above and improve an operational speed of CMOS processors through surface plasmon amplification by stimulated emission of radiation. Before discussing the embodiments directed to the method and system for improving operational efficiency of CMOS processors by surface plasmon amplification by stimulated emission of radiation, it may assist the reader to understand the various terms used herein by way of a general description of the terms in the following paragraphs.

A device that emits surface plasmons based on surface plasmon amplification by stimulated emission of radiation action maybe referred to as 'Spaser'. In other words, Spaser is a nanoscopic generator and amplifier of nanolocalized optical fields via surface plasmon amplification by stimulated emission of radiation (SPASER) action. In the following disclosure, the term 'Spaser' may be interchangeably referred to as 'Spaser device,' without departing from the broader scope of the disclosure. Further, the term 'SPASER action' may be interchangeably referred to as 'spasing,' without departing from the broader scope of this disclosure.

In general, a Spaser may include a resonant medium having at least one surface plasmon mode and an active (or, gain) medium. An energy source may apply energy to the active medium resulting in energy transition of an object that is present in the active medium. The object in the active medium may have significant transition strength. Example objects can include, but are not limited to, a rare-earth ion, a dye molecule, a semiconductor quantum dot, semiconductor quantum well, or nanoscopic layer of a semiconductor. The energy transition of the object in the active medium causes population inversion in the active medium which in turn stimulates the emission of at least one surface plasmon in the resonant medium. The process of applying energy to the active medium to cause a population inversion in the active medium may generally be referred to as a 'pumping' action or 'pumping the Spaser'. The structure of the Spaser, the operation of the Spaser, the pumping action, and other related operations associated with the SPASER action are described in greater detail in U.S. Patent Number 8,017,406 filed on April 30, 2009 in the name of Mark L. Stockman and David J. Bergman and entitled "Method for Surface Plasmon Amplification by Stimulated Emission of Radiation (SPASER)," which is divisional of U.S. Patent Number 7,569,188 filed on January 4, 2004 in the name of Mark L. Stockman and David J. Bergman and entitled "Surface Plasmon Amplification by Stimulated Emission of Radiation (SPASER)," which claims the benefit of, and priority to, U.S. Provisional Patent Application Number 60/437,760 filed on January 3, 2003.

Further, a summary of the theoretical aspects of Spasers are described in the following paper: D. J. Bergman and M. I. Stockman, 'Surface Plasmon Amplification by Stimulated Emission of Radiation: Quantum Generation of Coherent Surface Plasmons in Nanosystems', Phys. Rev. Lett. 90, 027402 (January 2003). A more detailed presentation of Spaser theory is described in paper [Stockman, M.I. The spaser as a nanoscale quantum generator and ultrafast amplifier. Journal of Optics 12, 024004-1-13 (2010)].

The term 'surface plasmons,' (herein 'SPs') as used herein may generally refer to coherent electron oscillations that exist at the interface between any two materials where the real part of the dielectric function changes sign across the interface (e.g. a metal-dielectric interface, such as a metal sheet in air). Accordingly, a Spaser can also be described as an apparatus for generation and amplification of nanoscale oscillating electric field via SPASER action.

Further, the term 'surface plasmon polaritons,' (herein 'SPPs') as used herein may generally refer to infrared or visible-frequency electromagnetic waves, which travel along a metal-dielectric or metal-air interface. The term surface plasmon polariton explains that the wave involves both charge motion in the metal ("surface plasmon") and electromagnetic waves in the air or dielectric ("polariton").

One advantage of using a Spaser is that the Spaser allows to send optical waves over the interconnect wires between transistor pairs of a CMOS processor, instead of electrostatically charging the interconnect wires and thereby help overcome the above-mentioned shortcomings associated with electrostatically charging of the interconnect wires as described in the background section. Another advantage of using a Spaser is that it has a modal volume that is smaller than that of microlasers which makes it correspondingly faster. Further, the smaller modal volume allows Spasers to be directly modulated at a speed in the THz range, which in turn opens up possibilities of using Spasers as a source of energy in high speed plasmon-polariton interconnects. Additional description regarding the use of Spasers as a source of energy in high speed plasmon-polariton interconnects is provided in the following paper: Dabing Li and Mark I. Stockman, Electric Spaser in the Extreme Quantum Limit, Phys. Rev. Lett. 110, 106803-1-5 (2013). As described above, using such Spaser driven interconnects allows increasing the speed of the processors and correspondingly decreasing the energy consumption and heat production per operation by the processors.

In one aspect, a processor includes a transistor pair of a first transistor and a second transistor. The first and second transistor pairs are configured to operationally communicate by sending optical waves over an interconnect wire that couples the first transistor to the second transistor. In particular, the first transistor of the transistor pair is coupled to a Spaser and the first transistor is configured to pump the Spaser which in turn outputs SPPs. The SPPs that are outputted from the Spaser are fed to an interconnect wire that is configured to propagate the SPPs. The SPPs propagated on the interconnect wire are detected by a phototransistor whose output current charges the gate of the second transistor of the transistor pair. In other words, optical waves transfer optical energy over the interconnect wire to the second transistor of the transistor pair, which, thus, provides the same functionality for the processor without electrostatically charging the interconnect wire.

These and other aspects, features, and embodiments of the present invention may be more clearly understood and appreciated from a review of the following detailed description of the disclosed embodiments and by reference to the drawings and claims

## BRIEF DESCRIPTION OF THE DRAWINGS

Example embodiments are illustrated by way of example and not limitation in the figures of the accompanying drawings, in which:

Figure 1A illustrates a conventional processor where the interconnect wires are electrostatically charged for operation of a transistor pair, according to certain exemplary embodiments.

Figure IB illustrates an interconnect architecture of a conventional processor, according to certain exemplary embodiments.

Figure 2 illustrates a processor that is configured for propagation of optical waves along an interconnect wire for operation of a transistor pair, according to certain exemplary embodiments.

Figure 3 is a flow chart that illustrates a method of improving an operation speed of a processor by surface plasmon amplification by stimulated emission of radiation, according to certain exemplary embodiments.

Many aspects of the invention can be better understood with reference to the above drawings. The elements and features in the drawings are not to scale; emphasis is instead being placed upon clearly illustrating the principles of example embodiments of the present invention. Moreover, certain dimensions may be exaggerated to help visually convey such principles. In the drawings, reference numerals designate like or corresponding, but not necessarily identical, elements throughout the several views. Other features of the present embodiments will be apparent from the Detailed Description that follows.

## DETAILED DESCRIPTION OF EXAMPLE EMBODIMENTS

Disclosed are a system and a method for improving operational efficiency of CMOS processors by surface plasmon amplification by stimulated emission of radiation. In exemplary embodiments of the present disclosure, a processor may include a pair of transistors that are coupled via an interconnect wire and communicate using nanolocalized optical fields propagated over the interconnect wire.

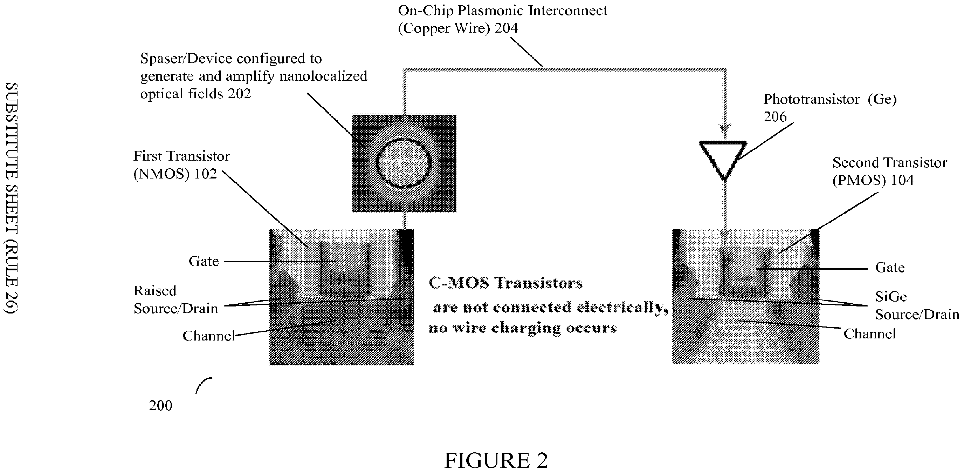

As described above and as illustrated in **Figure 1A,** interconnect wires may consume a large portion of the processor volume. In particular, these interconnect wires forms a bottom layer of a processor chip and are separated by distances that are proportional to the size of the transistors, i.e., approximately 20 nanometers (nm) based on current chip fabrication technology. In other words, the interconnect wires are very close to each other, which may lead to overlap of optical fields on one interconnect wire with the optical fields of a neighboring interconnect wire. The overlap of optical fields from one interconnect wire to another neighboring interconnect wire may lead to severe cross-talk. Accordingly, to avoid such cross-talk and overlap of optical fields, the optical fields propagated over the interconnect wires need to be localized at distances on the order of the wire radius, which is approximately 20 nm. Such localization of the optical fields as described above is achievable if the optical mode in the interconnect wire is a plasmonic mode, particularly surface plasmon polaritons (SPPs). Specifically for a cylindrical-symmetry wire, an SPP mode without cutoff is the $TM_0$ mode, which is an SPP of the type that is used in the adiabatic compression on a nanocone [Stockman, M.I. Nanofocusing of Optical Energy in Tapered Plasmonic Waveguides. Physical Review Letters 93, 137404-1-4 (2004); Giugni, A. et al. Hot-electron nanoscopy using adiabatic compression of surface plasmons. Nat. Nano 8, 845-852 (2013)], or its planar counterpart. In an example embodiment, propagating SPPs on the interconnect wire can be achieved by using Spasers as illustrated in **Figure 2** which is described in greater detail in the following paragraphs.

Turning to **Figure 2,** this figure illustrates a processor configured for optical waves to propagate along an interconnect wire for operation of a transistor pair, according to certain exemplary embodiments. In particular, **Figure 2** illustrates a configuration of a first transistor 102 and a second transistor 104 of an example transistor pair in a processor 200 to achieve an improved processor operational speed by SPASER action.

Referring to **Figure 2,** according to the invention, an output terminal of the first transistor 102 is coupled to an input of the Spaser 202 such that the Spaser is directly pumped by the first transistor 102. In one embodiment, the output terminal of the first transistor 102 may refer to a drain terminal. However, one or ordinary skill in the art can understand and appreciate that the Spaser 202 can alternatively be coupled to a source terminal of the first transistor 102. In yet another embodiment not part of the invention, the Spaser 202 may be electrically pumped by an external energy source other than the first transistor 102. In an example embodiment not part of the invention, the Spaser 202 can be pumped electrically via a nanowire with a ballistic resistance.

Continuing with **Figure 2,** an output of the Spaser 202 may be coupled to an interconnect wire which may be a copper wire, in one example. In another example, the interconnect wire 206 may be an aluminum wire or a doped semiconductor (conducting oxide) wire. In yet another example, the interconnect wire 206 may be any appropriate wire that has a propagating plasmonic mode or is capable of propagating SPPs. The interconnect wire is further coupled to a phototransistor 206 on an end that is different from the end that is coupled to the Spaser 202 such that the interconnect wire propagates an output of the Spaser 202 to the phototransistor 206. In one example, the phototransistor 206 as illustrated in **Figure 2** may be a germanium (Ge) near-field phototransistor, whereas in other example, the phototransistor 206 may be any appropriate photodetector that is capable of detecting SPPs. In addition, an output terminal of the phototransistor may be coupled to a gate terminal of the second transistor 104 for charging the second transistor 104.

In an example embodiment, the Spaser 202 can have a form factor that approximately matches the form factor of the first transistor 104 or the second transistor 102 for achieving high energy efficiency. In particular, the Spaser 202 can have a size ranging from approximately 10 nm to 100 nm. Accordingly, as described above, in an alternate embodiment, the Spaser 202 can form a constituent part of the first transistor 102, for example, the drain of the transistor. Further, the Spaser 202 is configured to follow modulation at speeds ranging from 1 terahertz (THz) to 10 THz. In other words, the Spaser is configured to allow direct modulation at least as fast as the first and/or the second transistors 102, 104. In addition, the Spaser 202 is configured to produce temporarily coherent intense fields with low noises.

In one embodiment, the metal used in a plasmonic core of the Spaser 202 can include gold and/or silver. In another embodiment, the metal used in the plasmonic core of the Spaser 202 can include metals that are CMOS compatible, such as aluminum or copper. In yet another embodiment, the plasmonic core of the Spaser 202 can include highly-doped conducting oxides which may be CMOS compatible.

One of ordinary skill in the art can understand and appreciate that replacing the Spaser 202 illustrated in **Figure 2** with spontaneous emitters, such as electrically-pumped diode that can directly emit SPPs is not outside the scope of this disclosure. However, it is advantageous to use a Spaser 202 instead of the spontaneous emitters because the Spaser 202 cannot be saturated (up to the limit of the material damage). This is because the stimulated emission rate of the Spaser 202 in the developed spasing regime is proportional to the pumping rate (current) with no saturation. In contrast, the spontaneous emission rate associated with spontaneous emitters is always limited by the exciton (electron-hole) lifetime. Additionally, the Spaser 202 has an advantage of reduced fluctuations compared to the spontaneous emitters because Spasers produce coherent fields with low noises as described above.

The relation of the stimulated emission rate of the Spaser with the pumping rate (current) as mentioned above is described in greater detail in the following papers: Dabing Li and Mark I. Stockman, Electric Spaser in the Extreme Quantum Limit, Phys. Rev. Lett. 110, 106803-1-5 (2013), and M. I. Stockman, Spaser as Nanoscale Quantum Generator and Ultrafast Amplifier, J. Opt. 12, 024004-1-13 (2010).

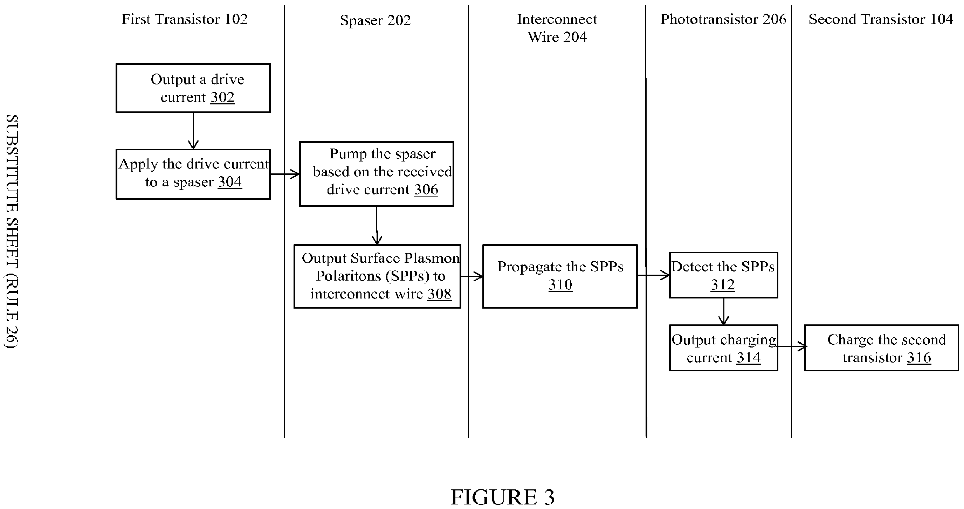

Turning to **Figure 3,** this figure is a flow chart that illustrates a method of improving an operation speed of processor by surface plasmon amplification by stimulated emission of radiation, according to certain exemplary embodiments. In operations 302 and 304, the first transistor 102 outputs a drive current and applies the drive current to the Spaser 202. In operation 306, the drive current from the first transistor 102 pumps the Spaser 202. As described above, the electrical pumping of the Spaser 202 can be done via a nanowire with a ballistic resistance. Upon pumping, in operation 308, the Spaser 202 generates SPs. In addition, in operation 308, the generated SPs are coupled in the near-field to the propagating SPPs of the interconnect wire 204. In other words, in operation 308, the Spaser 202 outputs SPPs which are then fed to the interconnect wire 204. Then, in operation 310, the interconnect wire 204 propagates the SPPs outputted by the Spasers 202 across the chip.

In operation 312, the SPPs on the interconnect wire are detected by the phototransistor 206 that is coupled to another end of the interconnect wire 204. In response to detecting the SPPs, in operation 314, the phototransistor 206 generates an output current or charging current that is applied to a gate terminal of the second transistor 104. Further, in operation 316, the second transistor 104 is charged based on the output current of the phototransistor 206.

Although specific operations are disclosed in the flowcharts illustrated in **Figure 3,** such operations are exemplary. That is, embodiments of the present invention are well suited to performing various other operations or variations of the operations recited in the flowcharts. It is appreciated that the operations in the flowcharts illustrated in **Figure 3** may be performed in an order different that presented, and that not all of the operations in the flowcharts may be performed.

The following section theoretically illustrates that the Spaser generates SPPs in sufficient numbers so that there will be enough photoelectrons produced in the near-field photodetector to charge the gate of the second transistor.

Quantitative demonstration: Spaser can generate sufficient SPPs to trigger a phototransistor to produce photoelectrons to charge the gate of a receiving transistor

The number of electrons that charge the gate of the second transistor, e.g., MOSFET to a potential difference $\Delta U = 0.2$ V to 0.3 V, is

$$N_e = \frac{C_g \Delta U}{e} \sim 200\text{-}300, \qquad (3)$$

where 'e' is elementary charge, and $C_g$ is the gate capacitance which is represented by the following Equation 4:

$$C_g = \frac{\varepsilon_{ox} S}{2\pi d}, \qquad (4)$$

where $\varepsilon_{ox} \sim 10$ is the gate-oxide permittivity, $S \sim (30nm)^2$ is the gate area, and $d \sim 1$ nm is the oxide thickness.

Further, the number of SPs that a Spaser 202 produces during a transistor switch (flop) time $T_{fl0p} \sim 3$ picosecond (ps) (i.e., shortest transistor flop time) can be determined to be approximately $1.5 \times 10^3$ by using following Equation 5:

$$N_{SP} \sim \frac{N_c \omega_n T_{flop}}{\pi}, \qquad (5)$$

where $N_c \sim 1$ is the number of the open quantum channels in a nanowire, and $\omega_n \sim 1$ eV/$\hbar$ is the Spaser 202 (angular) frequency. For a reasonable efficiency of the near-field phototransistor, the number of SPs ~ 1.5 x 10$^3$ can produce approximately 200-300 electrons that can charge the gate of the second transistor 104 to a potential difference of $\Delta$ U = 0.2 V to 0.3 V.

From the description of the example embodiments, equivalents of the elements shown therein will suggest themselves to those skilled in the art, and ways of constructing other embodiments will appear to practitioners of the art. Therefore, the scope of the present disclosure is to be limited only by the claims that follow. Further, the specification and drawings are to be regarded in an illustrative rather than a restrictive sense.

**Claims**

1. A system (200), comprising:

   a device (202) that is configured to generate and amplify nanolocalized optical fields via a Surface Plasmon Amplification by Stimulated Emission of Radiation, SPASER, action;
   a first transistor (102) of a CMOS transistor pair coupled to the device (202) and configured to supply drive current to the device (202) to initiate a pumping action associated with the SPASER action, wherein responsive to the drive current, the device (202) is configured to generate surface plasmons, SPs, that are coupled in a near-field to propagating surface plasmon polaritons, SPPs, of an interconnect wire (204), and wherein an output of the first transistor (102) is coupled to the device (202) such that the drive current supplied by the first transistor (102) provides a direct electrical pumping for the SPASER action, and the device (202) is configured to allow direct pumping by the first transistor (102) to initiate the SPASER action;
   a phototransistor (206) coupled to the device (202) via the interconnect wire (204); and
   a second transistor (104) of the CMOS transistor pair coupled to an output of the phototransistor (206) and configured to receive an output current from the phototransistor (206),
   wherein responsive to detection of the SPPs the phototransistor is configured to generate the output current for charging a gate of the second transistor.

2. The system (200) of Claim 1, wherein the device (202) is connected to one of a drain or a source of the first transistor (102).

3. The system (200) of Claim 1, wherein:

   the device (202) is configured such that a form factor of the device (202) is substantially similar to a form factor of the first transistor (102); and/or
   the device (202) is configured for direct modulation of the SPASER action at a speed that is substantially similar to the working frequency of at least one of the first transistor (102) and the second transistor (104) of the transistor pair; and/or
   the phototransistor (206) applies the output current to a gate of the second transistor (104) of the transistor pair; and/or
   the interconnect wire (204) comprises a plasmonic copper wire capable of propagating the SPPs.

4. The system (200) of Claim 1, wherein:

   the interconnect wire (204) comprises an aluminum wire; or
   the interconnect wire (204) comprises a doped semiconductor wire.

5. A method for generating and amplifying nanolocalized optical fields via Surface Plasmon Amplification by Stimulated Emission of Radiation, SPASER, action, by a nanostructure, the method comprising:

   receiving, by the nanostructure, an electrical energy to initiate a pumping action associated with the SPASER action, wherein the electrical energy is received from a first transistor of a CMOS transistor pair, and wherein an output of the first transistor is coupled to the nanostructure such that the electrical energy supplied by the first transistor provides a direct electrical pumping for the SPASER action, and the nanostructure is configured to allow direct pumping by the first transistor to initiate a SPASER action; and
   responsive to initiating the pumping action, outputting, by the nanostructure, surface plasmon polaritons, SPPs, to a plasmonic interconnect wire that propagates the SPPs to a light-sensitive transistor that is configured to detect the SPPs and charge a gate of a second transistor associated with the CMOS transistor pair, wherein the ouput of the light sensitive transistor is coupled to the gate of the second transistor.

6. The method of Claim 5, wherein the step of outputting the SPPs further comprises generating, by the nanostructure, surface plasmons, SPs, that are coupled in the near-field to the propagating, SPPs, of the plasmonic interconnect wire.

7. The method of Claim 5, wherein:
the plasmonic interconnect wire is a copper wire capable of propagating the SPPs.

8. The method of Claim 5, wherein:
the form factor of the nanostructure approximately matches the form factor of at least one of the transistors of the transistor pair.

9. The method of Claim 5, wherein responsive to detection of the SPPs by the light-sensitive transistor, the light-sensitive transistor is configured to generate an output current that charges the gate of the transistor.


**Patentansprüche**

1. System (200), umfassend:

eine Vorrichtung (202), die dazu konfiguriert ist, nanolokalisierte optische Felder über eine Oberflächenplasmonenverstärkung durch stimulierte Emission von Strahlung (Surface Plasmon Amplification by Stimulated Emission of Radiation, SPASER) zu erzeugen und zu verstärken;
einen ersten Transistor (102) eines CMOS-Transistorpaares, der mit der Vorrichtung (202) gekoppelt und dazu konfiguriert ist, der Vorrichtung (202) einen Treiberstrom zuzuführen, um einen Pumpvorgang zu initiieren, der mit der SPASER-Aktion verbunden ist, wobei die Vorrichtung (202) als Reaktion auf den Treiberstrom dazu konfiguriert ist, Oberflächenplasmonen (Surface Plasmons, SPs) zu erzeugen, die in einem Nahfeld mit sich ausbreitenden Oberflächenplasmonenpolaritonen (Surface Plasmon Polaritons, SPPs) eines Verbindungsdrahtes (204) gekoppelt sind, und wobei ein Ausgang des ersten Transistors (102) mit der Vorrichtung (202) gekoppelt ist, so dass der von dem ersten Transistor (102) gelieferte Treiberstrom ein direktes elektrisches Pumpen für die SPASER-Aktion bereitstellt, und die Vorrichtung (202) dazu konfiguriert ist, ein direktes Pumpen durch den ersten Transistor (102) zu ermöglichen, um die SPASER-Aktion zu initiieren;
einen Fototransistor (206), der über den Verbindungsdraht (204) mit der Vorrichtung (202) gekoppelt ist; und
einen zweiten Transistor (104) des CMOS-Transistorpaars, der mit einem Ausgang des Fototransistors (206) gekoppelt und dazu konfiguriert ist, einen Ausgangsstrom von dem Fototransistor (206) zu empfangen,
wobei der Fototransistor als Reaktion auf die Erfassung der SPPs dazu konfiguriert ist, den Ausgangsstrom zum Laden eines Gates des zweiten Transistors zu erzeugen.

2. System (200) nach Anspruch 1, wobei die Vorrichtung (202) mit einem aus einem Drain oder einer Source des ersten Transistors (102) verbunden ist.

3. System (200) nach Anspruch 1, wobei:

die Vorrichtung (202) so konfiguriert ist, dass ein Formfaktor der Vorrichtung (202) im Wesentlichen gleich einem Formfaktor des ersten Transistors (102) ist; und/oder
die Vorrichtung (202) für eine direkte Modulation der SPASER-Aktion mit einer Geschwindigkeit konfiguriert ist, die im Wesentlichen der Arbeitsfrequenz von mindestens einem aus dem ersten Transistor (102) und dem zweiten Transistor (104) des Transistorpaares ähnlich ist; und/oder
der Fototransistor (206) den Ausgangsstrom an ein Gate des zweiten Transistors (104) des Transistorpaares angelegt; und/oder
der Verbindungsdraht (204) einen plasmonischen Kupferdraht umfasst, der in der Lage ist, die SPPs weiterzuleiten.

4. System (200) nach Anspruch 1, wobei:

der Verbindungsdraht (204) einen Aluminiumdraht umfasst; oder
der Verbindungsdraht (204) einen dotierten Halbleiterdraht umfasst.

**5.** Verfahren zum Erzeugen und Verstärken nanolokalisierter optischer Felder mittels Oberflächenplasmonenverstärkung durch stimulierte Emission von Strahlung (Surface Plasmon Amplification by Stimulated Emission of Radiation, SPASER) durch eine Nanostruktur, wobei das Verfahren umfasst:

Empfangen einer elektrischen Energie durch die Nanostruktur, um eine Pumpaktion zu initiieren, die mit der SPASER-Aktion verbunden ist, wobei die elektrische Energie von einem ersten Transistor eines CMOS-Transistorpaares empfangen wird, und wobei ein Ausgang des ersten Transistors mit der Nanostruktur gekoppelt ist, so dass die von dem ersten Transistor gelieferte elektrische Energie ein direktes elektrisches Pumpen für die SPASER-Aktion bereitstellt, und die Nanostruktur dazu konfiguriert ist, direktes Pumpen durch den ersten Transistor zu ermöglichen, um eine SPASER-Aktion zu initiieren; und als Reaktion auf das Initiieren des Pumpvorgangs, Ausgeben von Oberflächenplasmonenpolaritonen, SPPs, durch die Nanostruktur an einen plasmonischen Verbindungsdraht, der die SPPs an einen lichtempfindlichen Transistor weiterleitet, der dazu konfiguriert ist, die SPPs zu ermitteln und ein Gate eines zweiten Transistors, der dem CMOS-Transistorpaar zugehörig ist, zu laden, wobei der Ausgang des lichtempfindlichen Transistors mit dem Gate des zweiten Transistors gekoppelt ist.

**6.** Verfahren nach Anspruch 5, wobei der Schritt zum Ausgeben der SPPs des Weiteren das Erzeugen, durch die Nanostruktur, von Oberflächenplasmonen, SPs, umfasst, die in dem Nahfeld mit den sich ausbreitenden SPPs des plasmonischen Verbindungsdrahtes gekoppelt sind.

**7.** Verfahren nach Anspruch 5, wobei:

der plasmonische Verbindungsdraht ein Kupferdraht ist, der in der Lage ist, die SPPs weiterzuleiten.

**8.** Verfahren nach Anspruch 5, wobei:

der Formfaktor der Nanostruktur annähernd dem Formfaktor von mindestens einem der Transistoren des Transistorpaares entspricht.

**9.** Verfahren nach Anspruch 5, wobei als Reaktion auf die Ermittlung der SPPs durch den lichtempfindlichen Transistor der lichtempfindliche Transistor dazu konfiguriert ist, einen Ausgangsstrom zu erzeugen, der das Gate des Transistors lädt.

**Revendications**

**1.** Système (200), comprenant :

un dispositif (202) qui est configuré pour générer et amplifier des champs optiques nanolocalisés via une action d'amplification par plasmons de surface par émission stimulée de rayonnement, SPASER, soit Surface Plasmon Amplification by Stimulated Emission of Radiation ;
un premier transistor (102) d'une paire de transistors CMOS couplé au dispositif (202) et configuré pour fournir un courant d'attaque au dispositif (202) pour initier une action de pompage associée à l'action SPASER, où, en réponse au courant d'attaque, le dispositif (202) est configuré pour générer des plasmons de surface, SP, soit Surface Plasmons, qui sont couplés dans un champ proche à des plasmons polaritons de surface, SPP, soit Surface Plasmon Polaritons, de propagation d'un fil d'interconnexion (204), et où une sortie du premier transistor (102) est couplée au dispositif (202) de sorte que le courant d'attaque fourni par le premier transistor (102) fournisse un pompage électrique direct pour l'action SPASER, et le dispositif (202) est configuré pour permettre un pompage direct par le premier transistor (102) pour initier l'action SPASER ;
un phototransistor (206) couplé au dispositif (202) via le fil d'interconnexion (204) ; et
un deuxième transistor (104) de la paire de transistors CMOS couplé à une sortie du phototransistor (206) et configuré pour recevoir un courant de sortie provenant du phototransistor (206),
dans lequel, en réponse à la détection des SPP, le phototransistor est configuré pour générer le courant de sortie pour charger une grille du deuxième transistor.

**2.** Système (200) de la revendication 1, dans lequel le dispositif (202) est relié à l'un(e) d'un drain ou d'une source du premier transistor (102).

**3.** Système (200) de la revendication 1, dans lequel :

le dispositif (202) est configuré de sorte qu'un facteur de forme du dispositif (202) soit essentiellement similaire à un facteur de forme du premier transistor (102) ; et/ou

le dispositif (202) est configuré pour une modulation directe de l'action SPASER à une vitesse qui est essentiellement similaire à la fréquence de travail d'au moins l'un du premier transistor (102) et du deuxième transistor (104) de la paire de transistors ; et/ou

le phototransistor (206) applique le courant de sortie à une grille du deuxième transistor (104) de la paire de transistors ; et/ou

le fil d'interconnexion (204) comprend un fil de cuivre plasmonique capable de propager les SPP.

4. Système (200) de la revendication 1, dans lequel :

le fil d'interconnexion (204) comprend un fil d'aluminium ; ou
le fil d'interconnexion (204) comprend un fil de semi-conducteur dopé.

5. Procédé de génération et d'amplification de champs optiques nanolocalisés via une action d'amplification par plasmons de surface par émission stimulée de rayonnement, SPASER, soit Surface Plasmon Amplification by Stimulated Emission of Radiation, par une nanostructure, le procédé comprenant :

recevoir, par la nanostructure, une énergie électrique pour initier une action de pompage associée à l'action SPASER, où l'énergie électrique est reçue d'un premier transistor d'une paire de transistors CMOS, et où une sortie du premier transistor est couplée à la nanostructure de sorte que l'énergie électrique fournie par le premier transistor fournisse un pompage électrique direct pour l'action SPASER, et la nanostructure est configurée pour permettre un pompage direct par le premier transistor pour initier une action SPASER ; et
en réponse à l'initiation de l'action de pompage, délivrer en sortie, par la nanostructure, des plasmons polaritons de surface, SPP, soit Surface Plasmon Polaritons, à un fil d'interconnexion plasmonique qui propage les SPP vers un transistor photosensible qui est configuré pour détecter les SPP et charger une grille d'un deuxième transistor associé à la paire de transistors CMOS, où la sortie du transistor photosensible est couplée à la grille du deuxième transistor.

6. Procédé de la revendication 5, dans lequel l'étape de sortie des SPP comprend en outre la génération, par la nanostructure, de plasmons de surface, SP, soit Surface Plasmons, qui sont couplés dans le champ proche aux SPP de propagation du fil d'interconnexion plasmonique.

7. Procédé de la revendication 5, dans lequel :
le fil d'interconnexion plasmonique est un fil de cuivre capable de propager les SPP.

8. Procédé de la revendication 5, dans lequel :
le facteur de forme de la nanostructure correspond approximativement au facteur de forme d'au moins un des transistors de la paire de transistors.

9. Procédé de la revendication 5, dans lequel, en réponse à la détection des SPP par le transistor photosensible, le transistor photosensible est configuré pour générer un courant de sortie qui charge la grille du transistor.

EP 2 984 684 B1

Electric On-Chip Interconnect
(Copper Wire) 106

First Transistor 102
(NMOS)

Second Transistor
(PMOS) 104

Gate

Gate

Channel

SiGe
Source/Drain

Raised
Source/Drain

Channel

100

FIGURE 1A

FIGURE 1B

Core processor cross section illustrating metal interconnects 108

SUBSTITUTE SHEET (RULE 26)

EP 2 984 684 B1

On-Chip Plasmonic Interconnect
(Copper Wire) 204

Spaser/Device configured to
generate and amplify nanolocalized
optical fields 202

Phototransistor (Ge)
206

First Transistor
(NMOS) 102

Second Transistor
(PMOS) 104

Gate

Raised
Source/Drain

Channel

C-MOS Transistors
are not connected electrically,
no wire charging occurs

Gate

SiGe
Source/Drain

Channel

200

FIGURE 2

EP 2 984 684 B1

| First Transistor 102 | Spaser 202 | Interconnect Wire 204 | Phototransistor 206 | Second Transistor 104 |

Output a drive current 302

Apply the drive current to a spaser 304

Pump the spaser based on the received drive current 306

Output Surface Plasmon Polaritons (SPPs) to interconnect wire 308

Propagate the SPPs 310

Detect the SPPs 312

Output charging current 314

Charge the second transistor 316

FIGURE 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009065801 A1
- US 2010316078 A1
- EP 1939657 A
- US 8017406 B
- US 7569188 B
- US 43776003

**Non-patent literature cited in the description**

- **PACKAN, P. et al.** High performance 32 nm logic technology featuring 2nd generation high-k + metal gate transistors. *2009 IEEE International Electron Devices Meeting (IEDM),* 2009, 1-4
- **KRAUSZ, F. ; STOCKMAN, M.I.** Attosecond metrology: from electron capture to future signal processing. *Nature Photonics,* 2014
- **PASRICHA, S. ; DUTT, N.** On-chip Communication Architectures: System on Chip Interconnect. Morgan Kaufmann, 2008
- **D. J. BERGMAN ; M. I. STOCKMAN.** Surface Plasmon Amplification by Stimulated Emission of Radiation: Quantum Generation of Coherent Surface Plasmons in Nanosystems. *Phys. Rev. Lett.,* January 2003, vol. 90, 027402
- **STOCKMAN, M.I.** The spaser as a nanoscale quantum generator and ultrafast amplifier. *Journal of Optics,* 2010, vol. 12, 024004-1, 13
- **DABING LI ; MARK I. STOCKMAN.** Electric Spaser in the Extreme Quantum Limit. *Phys. Rev. Lett.,* 2013, vol. 110, 106803-1, 5
- **STOCKMAN, M.I.** Nanofocusing of Optical Energy in Tapered Plasmonic Waveguides. *Physical Review Letters,* 2004, vol. 93, 137404-1, 4
- **GIUGNI, A. et al.** Hot-electron nanoscopy using adiabatic compression of surface plasmons. *Nat. Nano,* 2013, vol. 8, 845-852
- **M. I. STOCKMAN.** Spaser as Nanoscale Quantum Generator and Ultrafast Amplifier. *J. Opt.,* 2010, vol. 12, 024004-1, 13